# EUROPÄISCHE PATENTSCHRIFT

(11) **EP 4 154 287 B1**
(45) Veröffentlichungstag und Bekanntmachung des Hinweises auf die Patenterteilung: **04.06.2025**
(21) Anmeldenummer: 21735174.1
(22) Anmeldetag: 09.06.2021
(51) Int. Cl.: H01H 3/30

(54) **FEHLERERKENNUNG IN FEDERSPEICHERANTRIEBEN VON MITTELSPANNUNGSSCHALTANLAGEN**
FAULT DETECTION IN SPRING-LOADED DRIVES OF MEDIUM-VOLTAGE SWITCHGEAR SYSTEMS
DÉTECTION DE DÉFAUTS DANS DES ENTRAÎNEMENTS À RESSORT DE SYSTÈMES DE COMMUTATION MOYENNE TENSION

(30) Priorität: 20.07.2020 DE 102020209017
(43) Veröffentlichungstag der Anmeldung: 29.03.2023
(73) Patentinhaber: Siemens Aktiengesellschaft, 80333 München (DE)
(72) Erfinder: HIRTE, Malte Georg, 15370 Petershagen (DE); LECHELER, Stefan, 12277 Berlin (DE)
(74) Vertreter: Siemens Patent Attorneys
(86) Internationale Anmeldenummer: PCT/EP2021/065379
(87) Internationale Veröffentlichungsnummer: WO 2022/017675

(56) Entgegenhaltungen:
- DE-A1- 102011 089 039
- DE-A1- 102016 218 334
- US-A1- 2017 047 181
- US-A1- 2017 047 181

## Beschreibung

### Technisches Gebiet

Die Erfindung betrifft ein Verfahren zum Betreiben eines Federspeicherantriebs einer Mittelspannungsschaltanlage, einen Federspeicherantrieb, der ausgebildet ist, das erfindungsgemäße Betriebsverfahren durchzuführen, und eine Mittelspannungsschaltanlage mit einem solchen Federspeicherantrieb.

### Technischer Hintergrund

Schalthandlungen in Mittelspannungsschaltanlagen wie insbesondere das Öffnen des Schalters durch Entfernen eines Bewegtkontaktes eines Schalters der Mittelspannungsschaltanlage von seinem Gegenkontakt müssen typischerweise innerhalb einer Spanne von einigen Millisekunden nach Eingang eines entsprechenden Steuersignals ausgeführt werden, um eine Gefährdung von Personal und Material möglichst weitgehend auszuschließen. Deshalb werden Federspeicherantriebe verwendet, die die für die Schalthandlung eines Schalters benötigte Energie vorhalten, um mit möglichst geringer Verzögerung auf ein entsprechendes Steuersignal reagieren zu können. Diese Federspeicherantriebe besitzen eine oder mehrere Federn, die über einen elektrischen Hilfsantrieb gespannt werden. Das Spannen der Feder(n) erfolgt dabei meist ohne gesteigerte Anforderungen an die Geschwindigkeit des Spannens. Der elektrische Hilfsantrieb ist üblicherweise über ein Getriebe mit der Feder verbunden beziehungsweise enthält ein solches.

In diesen Federspeicherantrieben können Fehler auftreten, die den Betrieb des Schalters beeinträchtigen und im Rahmen einer sicheren Betriebsführung der Mittelspannungsschaltanlage sicher und frühzeitig erkannt werden müssen, um Fehlschaltungen zu verhindern. Diese Fehler können im Federspeicherantrieb, in dessen elektrischen Hilfsantrieb oder in der Kombination von Federspeicherantrieb und elektrischem Hilfsantrieb begründet liegen.

Mögliche Fehler sind:
- Federermüdung (die in der Feder gespeicherte Energie wird kleiner im Laufe der Zeit)
- Federverstärkung (die in der Feder gespeicherte Energie wird größer im Laufe der Zeit)
- (zunehmende) mechanische Schwergängigkeit im Hilfsantrieb inklusive Getriebe
- Verschlechterung der elektrischen Kennwerte des Hilfsantriebs mit Reduzierung der gelieferten mechanischen Leistung
- Überlastung und daraus folgende Zerstörung des Hilfsantriebs inklusive des Getriebes

Aktuell sind keine ausreichenden Verfahren zur sicheren Erkennung von Fehlern und deren Zuordnung zu Einzelkomponenten eines Federspeicherantriebs während des Betriebes der Mittelspannungsschaltanlage verfügbar. Die bisher verwendeten Systeme können lediglich schwerwiegende Abweichungen erkennen, beispielsweise eine mangelnde Funktionsfähigkeit der Gesamtanordnung, und dies nur im Rahmen einer individuellen Prüfung. Dazu muss der Schalter von der Mittelspannung getrennt und ein spezielles Prüfgerät angeschlossen werden.

Vor diesem Hintergrund besteht Bedarf für ein Verfahren zum Betreiben eines Federspeicherantriebs einer Mittelspannungsschaltanlage, das eine Fehlererkennung während des bestimmungsgemäßen Betriebs der Mittelspannungsschaltanlage erlaubt.

Aus DE 10 2016 218 334 A1 ist eine Motorvorrichtung für einen Schalterantrieb eines elektrischen Schalters bekannt, mit einer Spannungsmesseinheit und einer Strommesseinheit bekannt. Aus US 2017/0047181 A1 ist ein Monitoring-System für einen Leistungsschalter eines Schaltanlage bekannt.

### Zusammenfassung der Erfindung

Das erfindungsgemäße Verfahren zum Betreiben eines Federspeicherantriebs einer Mittelspannungsschaltanlage weist wenigstens die folgenden Schritte auf:
- Messen eines Antriebsstroms eines elektrischen Hilfsantriebs zum Spannen einer Antriebsfeder des Federspeicherantriebs der Mittelspannungsanlage;
- Spannen der Antriebsfeder mit dem elektrischen Hilfsantrieb;
- Erstellen eines Auswertungsdatensatzes in Abhängigkeit von dem gemessenen Antriebsstrom;
- Vergleichen des Auswertungsdatensatzes mit einer Erwartung; und
- Ausgeben eines Wartungssignals in Abhängigkeit von einem Ergebnis des Vergleichens.

Im Schritt des Messens des Antriebsstroms wird ein zeitlicher Verlauf des Antriebsstroms gemessen. Dabei wird der Auswertungsdatensatz in Abhängigkeit von dem gemessenen zeitlichen Verlauf des Antriebsstroms erstellt. Außerdem wird im Schritt des Erstellens des Auswertungsdatensatzes ein Integral des zeitlichen Verlaufs des Antriebsstroms bestimmt. Das Integral des Antriebsstroms zeigt an, wieviel elektrische Energie für den vollständigen Spannvorgang aufgebracht wurde. Eine Zunahme dieser Größe ist ein gut geeigneter Indikator für eine Verschlechterung des Federspeicherantriebs.

Erfindungsgemäß wird dabei zudem ein erster Anteil des Integrals bestimmt, der eine von dem Hilfsantrieb geleistete Spannarbeit angibt. Dieser erste Anteil des Integrals kann sich insbesondere auf den zeitlichen Abschnitt des gemessenen zeitlichen Verlaufs beziehen, der sich von einem lokalen Minimum nach der Aktivierung des Hilfsantriebs bis zu dessen Deaktivierung erstreckt. Der erste Anteil des Integrals bietet eine Information darüber, ob und wie sich die Elastizität der Feder zeitlich verändert hat, was sich beispielsweise bei Erschlaffen der Feder in einer unerwünscht reduzierten Bewegungsgeschwindigkeit, mit der der Bewegtkontakt des Schalters während der Schalthandlung bewegt wird, niederschlagen kann.

Das Verfahren bietet den Vorteil, dass der Zustand des Federspeicherantriebs und seiner Komponenten wie Feder und Hilfsantrieb inklusive Getriebe bei einer gewöhnlichen Schalthandlung während des bestimmungsgemäßen Betriebs der Mittelspannungsschaltanlage erfasst und beurteilt werden kann. Die Ausgabe des Wartungssignals erlaubt, rechtzeitig vor dem Ausfall oder einer nicht hinnehmbarer Wahrscheinlichkeit einer Fehlfunktion des Federspeicherantriebs eine Wartungsmaßnahme zu planen und zu einer den über die Mittelspannungsschaltanlage versorgten oder gesteuerten Betrieb möglichst wenig beeinträchtigenden Zeit durchzuführen und auf diese Weise Stillstandszeiten möglichst weitgehend zu reduzieren.

Die Erfindung beruht auf der Einsicht und schließt diese mit ein, dass sich der Zustand des Federspeicherantriebs an dem Antriebsstrom des zum Spannen der Feder verwendeten elektrischen Hilfsantrieb ablesen lässt. Beispielsweise steigt der Antriebsstrom, wenn der Hilfsantrieb aufgrund einer zunehmenden mechanischen Schwergängigkeit des Getriebes oder der Motorlager des Hilfsantriebs ein größeres Drehmoment aufbringen muss. Der Strom kann jedoch auch sinken, wenn die Spannkraft der Feder wegen Materialermüdung über eine Vielzahl von Schalthandlungen hinweg abnimmt. Wird ein solcher Fall erkannt, kann das Wartungssignal dies anzeigen, so dass entsprechende Wartungsmaßnahmen eingeleitet werden können.

Als Mittelspannung wird vorliegend eine elektrische Spannung im Bereich von 1000 Volt bis etwa 52 Kilovolt bezeichnet.

Anhand einer Messung des zeitlichen Verlaufs des Antriebsstroms können mehrere Parameter bestimmt und beispielsweise sich in einer Einzelmessung aufhebende gegenläufige Effekte, die jeweils für sich eine Verschlechterung des Federspeicherantriebs bedeuten, voneinander unterschieden und erkannt werden. Dadurch führt die Messung des zeitlichen Verlaufs des Antriebsstroms zu einer höheren Wahrscheinlichkeit, dass eine Verschlechterung des Federspeicherantriebs rechtzeitig erkannt und die betroffene Komponente des Federspeicherantriebs bereits vor der einzuleitenden Wartungsmaßnahme identifiziert werden kann, so dass eine bessere Beurteilung der Dringlichkeit der Durchführung der Wartungsmaßnahme möglich wird.

Beispielsweise kann der zeitliche Verlauf anhand einer periodischen Messung des Momentanstroms des elektrischen Hilfsantriebs gemessen werden. Ebenso ist es möglich, zu bestimmten Zeitpunkten Einzelmessungen vorzunehmen, die Punkte des realen Verlaufs betreffen, die von besonderem Interesse beim Erstellen des Auswertungsdatensatzes sind. Hierbei fallen insgesamt weniger zu verarbeitende Messdaten an, was die Auswertung und Speicherung vereinfacht. Da sich diese Punkte oder wenigstens manche dieser Punkte aufgrund der zu beobachtenden Verschlechterung zeitlich verschieben können, kann auch vorgesehen sein, eine Serie von Einzelmessungen um diese Punkte herum vorzunehmen und zwischen diesen Serien nicht oder weniger häufig den Antriebsstrom zu messen.

Außerdem kann ein zweiter Anteil des Integrals bestimmt werden, der Antriebsverluste des Hilfsantriebs angibt. Dieser zweite Anteil des Integrals kann sich insbesondere auf einen zeitlichen Abschnitt des gemessenen zeitlichen Verlaufs, der sich von dem Zeitpunkt des Aktivierens des Hilfsantriebs bis zu dem oben erwähnten lokalen Minimum erstreckt, sowie auf einen Sockelbereich des zeitlichen Verlaufs beziehen, der nach oben durch die Stromstärke an diesem lokalen Minimum beschränkt wird. Der zweite Anteil des Integrals bietet eine Information, ob Motorlager, Getriebe und sonstige Umsetzungen und Übertragungen der Motorkraft des Hilfsantriebs bis in die Feder schwergängiger geworden sind oder sich in sonstiger Weise verschlechtert oder verändert haben.

In einer Kombination der beiden letztgenannten Ausführungsformen des erfindungsgemäßen Verfahrens können der erste und der zweite Anteil des Integrals zueinander ins Verhältnis gesetzt werden. Hierdurch können mehrere Fehlervarianten an einem einzigen Verhältniswert abgelesen werden, was den Schritt des Vergleichens mit der Erwartung vereinfachen kann.

Vorzugsweise wird beim Erstellen des Auswertungsdatensatzes wenigstens ein charakteristischer Zeitpunkt bestimmt. Dabei wird im Schritt des Vergleichens des Auswertungsdatensatzes der wenigstens eine charakteristische Zeitpunkt und/oder ein zu dem wenigstens einen charakteristische Zeitpunkt gemessener Antriebsstrom mit einem dem wenigstens einen charakteristischen Zeitpunkt zugeordneten Erwartungswert verglichen. Die charakteristischen Zeitpunkte werden beispielsweise relativ zu einem Startzeitpunkt des Aktivierens des Hilfsmotors bestimmt und bezeichnen Zeitpunkte, zu denen ein bekanntes Verhalten, das für einen gegebenen Typ des Federspeicherantriebs erwartet wird, erkennbar ist. Beispielsweise kann der wenigstens eine charakteristische Zeitpunkt ein Zeitpunkt ausgewählt sein aus:
- dem Beginn eines Stromflusses durch den Hilfsantrieb,
- dem Beginn des Spannens der Antriebsfeder,
- dem Auftreten eines lokalen oder globalen Maximums des Antriebsstroms,
- dem Abschaltzeitpunkt des Hilfsantriebs und
- dem Ende eines Stromflusses durch den Hilfsantrieb.

Die Erwartung, mit der der Auswertungsdatensatz verglichen wird, kann insbesondere ein historischer Datensatz oder ein für einen Typ des Federspeicherantriebs spezifischer vorgegebener Datensatz sein. Ein historischer Datensatz kann beispielsweise bei einer im Rahmen der Herstellung des Federspeicherantriebs während eines Probespannens der Feder gemäß den diesbezüglichen Verfahrensschritten des erfindungsgemäßen Verfahrens aufgezeichneter Datensatz desselben Federspeicherantriebs oder ein bei einer früheren Durchführung des erfindungsgemäßen Verfahrens aufgezeichneten Auswertungsdatensatz enthalten. Ein für den Typ des Federspeicherantriebs vorgegebener spezifischer Datensatz kann ein über Produktionsstreuungen hinweg verallgemeinertes Verhalten des Federspeicherantriebs beschreiben, wodurch das beschriebene Messen im Rahmen der Herstellung des Federspeicherantriebs zeit- und kostensparend entfallen kann.

Ein zweiter Erfindungsaspekt betrifft einen Federspeicherantrieb für eine Mittelspannungsschaltanlage, der einen elektrischen Hilfsantrieb, der ausgebildet ist, eine Antriebsfeder des Federspeicherantriebs zu spannen, und eine Messeinheit umfasst, die ausgebildet ist, einen Antriebsstrom des Hilfsantriebs zu messen. Die Messeinheit ist dabei außerdem dazu ausgebildet, ein Messergebnis zur Durchführung des Verfahrens des ersten Erfindungsaspektes an eine Steuereinheit zu übermitteln. Die Steuereinheit kann mit der Messeinheit als gemeinsame Einheit verwirklicht oder aber auch als separate Einheit außerhalb des Federspeicherantriebs, beispielsweise in einem digitalen Schutzgerät der Mittelspannungsanlage oder einer entfernten Steuerzentrale, verwirklich sein.

Ein weiterer Erfindungsaspekt führt eine Mittelspannungsschaltanlage mit einem Schalter, der einen Bewegtkontakt aufweist, und einem Federspeicherantrieb gemäß dem vorhergehenden Erfindungsaspekt, welcher ausgebildet ist, den Bewegtkontakt des Schalters auf ein Steuersignal hin zu bewegen, ein. Schließlich betrifft die Erfindung einen Datenspeicher mit einem Computerprogramm, das, von einer Steuereinheit, beispielsweise einer Steuereinheit eines Federspeicherantriebs, einer Mittelspannungsschaltanlage, eines digitalen Schutzgerätes oder einer entfernten Steuerzentrale, ausgeführt das erfindungsgemäße Verfahren durchführt.

### Kurzbeschreibung der Abbildungen

Die Erfindung wird nachfolgend anhand von Abbildungen von Ausführungsbeispielen näher erläutert. Es zeigen:
Fig. 1 ein Ausführungsbeispiel einer Mittelspannungsschaltanlage mit einem erfindungsgemäßen Federspeicherantrieb;
Fig. 2 ein Beispiel für einen zeitlichen Verlauf eines Antriebsstrom eines elektrischen Hilfsantriebs des erfindungsgemäßen Federspeicherantriebs; und
Fig. 3 ein Ausführungsbeispiel eines erfindungsgemäßen Verfahrens zum Betreiben des Federspeicherantriebs.

### Ausführliche Figurenbeschreibung

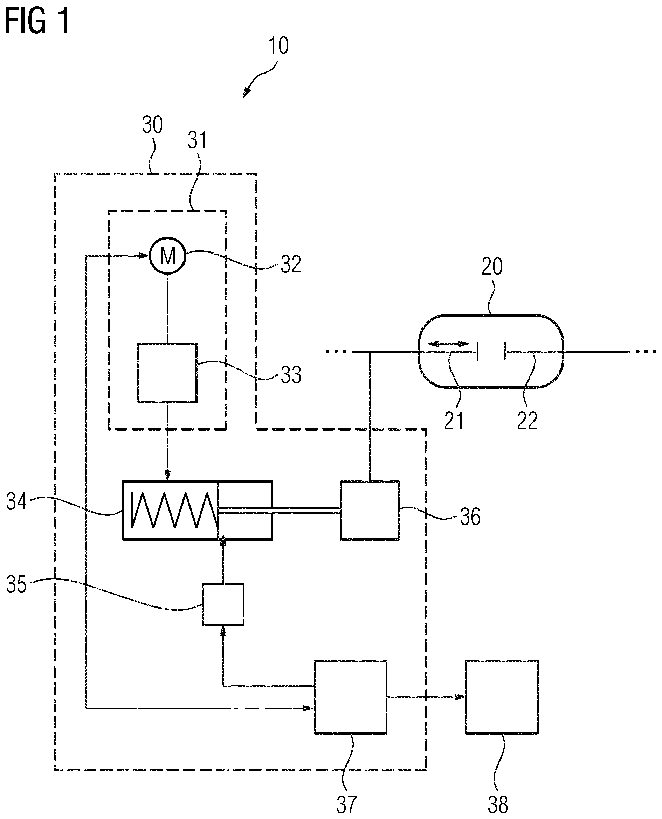

Fig. 1 zeigt ein Ausführungsbeispiel einer Mittelspannungsschaltanlage 10 mit einem erfindungsgemäßen Federspeicherantrieb 30. Der Federspeicherantrieb 30 ist mit einem Bewegtkontakt 21 eines Schalters 20 der Mittelspannungsschaltanlage 10 verbunden und dazu ausgebildet, den Bewegtkontakt 21 für die Durchführung einer Schalthandlung schnell und mit möglichst geringer Verzögerung zu bewegen (insbesondere im Zuge des Öffnens des Schalters 20 von einem Gegenkontakt 22 wegzubewegen).

Zu diesem Zweck besitzt der Federspeicherantrieb 30 eine Antriebsfeder 34, die in gespanntem Zustand die für das gewünschte schnelle Bewegen des Bewegtkontaktes 21 benötigte Energie als Federenergie vorhält, um diese, ausgelöst durch einen Auslöser 35, im Gebrauchsfall schnell freizugeben. Bei dem gezeigten Ausführungsbeispiel ist die Antriebsfeder 34 mittelbar über eine Umsetzung 36, die beispielsweise einen an einer Welle gelagerten Hebelarm oder dergleichen umfassen kann, mit dem Bewegtkontakt 21 verbunden, es sind jedoch auch Ausführungsformen denkbar, bei denen die Antriebsfeder 34 unmittelbar mit dem Bewegtkontakt 21 verbunden ist.

Der Federspeicherantrieb 30 kann weitere Antriebsfedern für das Öffnen oder Schließen enthalten, ggf. parallel für mehrere Schalthandlungen in einer Zeitspanne, die kürzer ist als die Dauer eines erneuten Spannens einer jeweiligen ausgelösten Antriebsfeder.

Der Federspeicherantrieb 30 besitzt außerdem einen elektrischen Hilfsantrieb 31, der dazu vorgesehen ist, die Antriebsfeder 34 nach deren Auslösen erneut zu spannen. Im hier gezeigten Ausführungsbeispiel umfasst der elektrische Hilfsantrieb 31 einen Elektromotor 32, der über ein Getriebe 33 mit der Antriebsfeder 34 verbunden oder verbindbar ist.

Die Verbindung von Antriebsfeder 34 und elektrischem Hilfsantrieb 31 kann auf vielfältige Weise nach im technischen Gebiet bekannter Art verwirklicht werden. Beispielsweise kann das Getriebe 33 mit einem Hebel verbunden sein, der durch das Getriebe geschwenkt wird und ein Federauge besitzt, in das die Antriebsfeder eingehängt ist. Durch das Schwenken des Hebels wird die Antriebsfeder gespannt (oder komprimiert, was im Rahmen der Erfindung unter einer Bezeichnung "spannen" zusammengefasst wird) und somit mit Federenergie beaufschlagt.

Der Federspeicherantrieb des Ausführungsbeispiels von Figur 1 besitzt ferner eine Mess- und/oder Steuereinheit 37, die dazu ausgebildet ist, den Auslöser 35 für das Auslösen der Antriebsfeder 34 anzusteuern und anschließend den elektrischen Hilfsantrieb 31 beziehungsweise den Elektromotor 32 zu aktivieren, um die Antriebsfeder 34 wieder zu spannen. Der Auslöser 35 kann beispielsweise eine mechanische Blockade des Getriebes 33 umfassen, die durch den Auslöser freigegeben wird, so dass ein Freilauf des Getriebes aktiviert und die Antriebsfeder freigegeben wird.

Die Mess- und/oder Steuereinheit 37 ist in Figur 1 als einzelne Einheit dargestellt, die Teil der Federspeicherantriebs 30 ist, kann jedoch auch als verteilte Anordnung aus beispielsweise einer Messeinheit und einer von dieser entfernt angeordneten Steuereinheit verwirklicht sein. In einem solchen Fall kann die Messeinheit in dem Federspeicherantrieb und die Steuereinheit in einem digitalen Schutzgerät in der Mittelspannungsschaltanlage oder an einem entfernten Ort wie einer Steuerzentrale angeordnet sein. Auch die dargestellten Funktionen der Steuereinheit können auf mehrere Einheiten aufgeteilt sein. Beispielsweise kann die Ansteuerung des Auslösers 35 von einer im Federspeicherantrieb 30 angeordneten Einheit, die nachfolgend beschriebene Auswertung der Messwerte jedoch in einer anderen, insbesondere entfernten Einheit erfolgen.

Die Mess- und/oder Steuereinheit 37 ist dazu ausgebildet, einen Antriebsstrom des elektrischen Hilfsantriebs 31 während des Spannens der Antriebsfeder 34 zu messen und anhand des gemessenen Antriebsstroms auf einen Zustand des Federspeicherantriebs 30 und/oder bestimmter Komponenten des Federspeicherantriebs 30 zu schließen. Ein Ergebnis dieser Bewertung kann als Wartungssignal an einen Signalempfänger 38, der beispielsweise eine Anzeige der Mittelspannungsschaltanlage 10 oder auch eine entfernte Steuerzentrale sein kann, ausgegeben werden, um den Grad der Notwendigkeit einer Wartungsmaßnahme und ggf. die eine Wartung benötigende Komponente des Federspeicherantriebs 30 anzuzeigen.

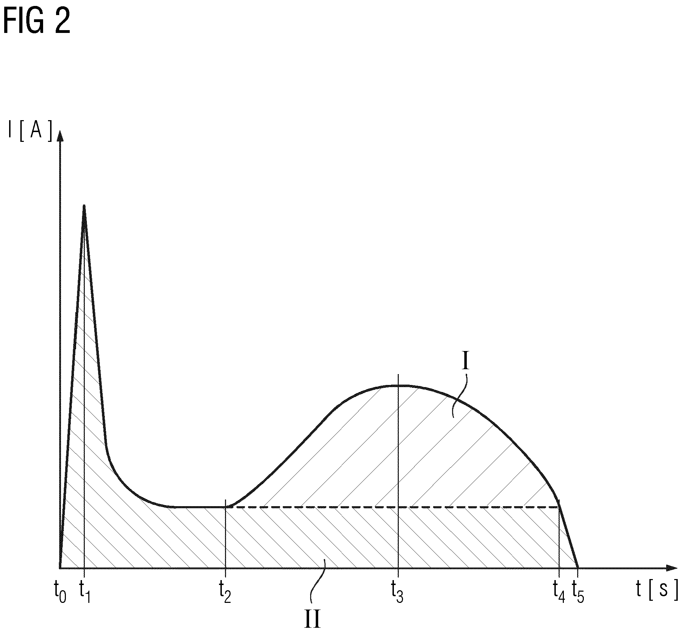

Fig. 2 zeigt ein Beispiel für einen zeitlichen Verlauf eines Antriebsstrom I eines elektrischen Hilfsantriebs 31 des Federspeicherantriebs 30, wie er beispielsweise von der Mess- und/oder Steuereinheit 37 des in Figur 1 gezeigten Ausführungsbeispiels gemessen werden kann. Der dargestellte typische zeitliche Verlauf des Antriebsstroms erstreckt sich in üblichen Anwendungen über eine Zeitspanne von weniger als 10 Sekunden, beispielsweise über 3 bis 5 Sekunden. Zu einem Zeitpunkt t₀ wird der elektrische Hilfsantrieb aktiviert, woraufhin sich, in der Anstiegsgeschwindigkeit begrenzt durch die Induktivität der Motorwicklungen des Elektromotors 32, bis zu einem Zeitpunkt t₁ ein sehr hoher Antriebsstrom einstellt. Der schnell ansteigende Antriebsstrom baut ein Magnetfeld in den Motorwicklungen auf, welches für die Motorbewegung ursächlich ist. Zum Zeitpunkt t₁ beginnt der Elektromotor 32, sich zu drehen, wodurch ein generatorischer Effekt der Drehung eine der Ursache entgegenwirkende Gegenspannung erzeugt, weshalb mit dem Beginn des Drehens des Elektromotors 32 zum Zeitpunkt t₁ der Antriebsstrom wieder abnimmt. Nachdem Anlaufen des Elektromotors 32 nimmt der Antriebsstrom ab, um dann bis zu einem Zeitpunkt t₂ auf einem Plateau zu verbleiben, das den noch ohne mechanische Last, also vor Beginn der Spannarbeit, laufenden Elektromotor 32 kennzeichnet. Der in dieser Zeitspanne aufgewandte Strom ist erforderlich, um Verluste im Elektromotor 32, dem Getriebe 32 und den sonstigen mit dem Elektromotor 32 verbundenen beweglichen Komponenten zu überwinden. Dementsprechend enthalten während des Plateaus gemessene Antriebsstrommesswerte eine Information über den Zustand der genannten Komponenten.

Ab dem Zeitpunkt t₂ steigt der Antriebsstrom erneut an, um zu einem Zeitpunkt t₃ ein (lokales) Maximum zu erreichen. Der Anstieg des Antriebsstroms wird durch das für das Spannen der Antriebsfeder 34 erforderliche zusätzliche Drehmoment verursacht. Zum Zeitpunkt t₂ beginnt somit das eigentliche Spannen der Antriebsfeder 34, das heißt, es wird ab diesem Zeitpunkt durch den elektrischen Hilfsantrieb 31 Federenergie in die Antriebsfeder 34 eingebracht. Die Antriebsfeder 34 wird weiter gespannt, bis zu einem Zeitpunkt t₄ der elektrische Hilfsantrieb 31 deaktiviert wird. Dieser Zeitpunkt kann insbesondere durch die Position der Antriebsfeder 34 beziehungsweise einer mechanisch mit der Antriebsfeder 34 verbundenen Komponente wie beispielsweise auch des Elektromotors 32 selbst bestimmt werden. Beispielsweise kann ein Hilfsschalter mittelbar oder unmittelbar durch die Antriebsfeder 34 betätigt werden, wenn diese eine vorgesehene Endposition erreicht hat, wodurch durch den Hilfsschalter der Antriebsstromkreis des elektrischen Hilfsantriebs unterbrochen wird. Es ist aber auch denkbar, den Zeitpunkt t₄ für einen gegebenen Federspeicherantrieb fest zu wählen und für den Betrieb der Mittelspannungsschaltanlage anzunehmen, dass zu diesem Zeitpunkt die Antriebsfeder 34 weit genug gespannt ist.

Nach dem Deaktivieren des elektrischen Hilfsantriebs zum Zeitpunkt t₄ fällt der Antriebsstrom schnell ab, bis er zu einem Zeitpunkt t₅ Null wird. Während dieser Zeit fließender Strom kann beispielsweise, aufrechterhalten durch die Induktivität der Motorwicklungen, in einem Lichtbogen in dem erwähnten Hilfsschalter fließen, bis die Motorwicklungen entmagnetisiert sind.

Die Steuereinheit 37 kann den Antriebsstrom des elektrischen Hilfsantriebs 31 auf unterschiedliche Weise messen. Beispielsweise ist bei besonders einfachen Ausführungsbeispielen möglich, den Antriebsstrom nur einmalig zu einem vorbestimmten Zeitpunkt nach dem Aktivieren des elektrischen Hilfsantriebs zu messen, beispielsweise zu einem Zeitpunkt t₃', der dem erwarteten Zeitpunkt des Auftretens des (lokalen) Maximums des Antriebsstroms (Zeitpunkt t₃ in Figur 2) entspricht. Weicht der zu diesem Zeitpunkt gemessene Wert des Antriebsstroms von einer Erwartung ab, kann dies beispielsweise auf ein Ermüden der Antriebsfeder (weniger Antriebsstrom wird benötigt, um die Antriebsfeder zu spannen), ein Ansteigen der Reibungsverluste in Elektromotor und/oder Getriebe (mehr Antriebsstrom wird benötigt, um die Antriebsfeder zu spannen), zunehmendes mechanisches Spiel im elektrischen Hilfsmotor (das lokale Maximum wird erst später erreicht) und andere Alterungseffekte mehr hinweisen. Da manche dieser Effekte gegenläufig sind, können sie sich bei gleichzeitigem Auftreten maskieren, so dass wiederholte Messungen von Vorteil sind.

Die Messungen können beispielsweise periodisch wiederholt werden, etwa wenigstens alle 50 Millisekunden. In praktischen Ausführungsbeispielen wird der Antriebsstrom in Abständen von 1 Millisekunde und weniger gemessen, beispielsweise mit einer Abtastfrequenz von 8 Kilohertz.

Alternativ zu der einmaligen oder der periodischen Messung können aber auch mehrere zeitlich nicht gleichverteilte Messungen des Antriebsstroms, nämlich zu den erwarteten Zeitpunkten des Auftretens der oder einiger der als t₁ bis t₅ beschriebenen charakteristischen Zeitpunkte, durchgeführt werden. Beispielsweise kann zu einem mit hoher Wahrscheinlichkeit zwischen den Zeitpunkten t₁ und t₂ der Figur 2 liegenden Zeitpunkt t₂' gemessen werden, um einen für den lastfreien Betrieb des elektrischen Hilfsantriebs 31 charakteristischen Messwert zu erhalten. Anschließend kann ein zu dem zwischen den Zeitpunkten t₂ und t₄ der Figur 2 liegenden Zeitpunkt t₃' erneut gemessen werden, um einen Messwert zu gewinnen, aus dem sich ein Maß der vom elektrischen Hilfsantrieb 31 aufgebrachten Spannarbeit zu erhalten. Ein solches Verfahren ist einfach auszuführen, bietet gegenüber einer einzigen Messung des Antriebsstromes aber bereits eine zuverlässigere Erkennung verschiedener Alterungseffekte.

Es ist auch möglich, innerhalb einer Zeitspanne um die erwarteten Zeitpunkte des Auftretens der für eine spezielle Ausführungsform des erfindungsgemäßen Betriebsverfahrens zu berücksichtigenden charakteristischen Zeitpunkte herum eine Serie von Messungen durchzuführen und die Messungen dann bis zum Heranrücken des nächsten (erwarteten) charakteristischen Zeitpunkts zu unterbrechen. Innerhalb jeder Serie von Messungen kann dann das jeweilige Maximum oder Minimum mit dem zugehörigen Messzeitpunkt als tatsächlicher charakteristischer Zeitpunkt betrachtet und für die Auswertung verwendet werden. Hierdurch werden die Anzahl der Messungen und die für die Auswertung zu verarbeitenden Daten gegenüber einer kontinuierlichen oder periodischen Messung des Antriebsstroms reduziert, aber dennoch eine vergleichbare Zuverlässigkeit der Erkennung von Alterungseffekten im Federspeicherantrieb erreicht.

In Figur 2 entspricht die Fläche unter dem zeitlichen Verlauf des Antriebsstroms dem Integral des Antriebsstroms, welches wiederum die gesamte für das Spannen der Antriebsfeder aufgebrachte Energie bezeichnet. Dieses Integral kann in zwei in Figur 2 durch unterschiedliche Schraffierungen angezeigte Teile zerlegt werden, von denen der Teil I (erster Teil des Integrals des Antriebsstroms) die tatsächlich in die Antriebsfeder eingebrachte Federenergie und der Teil II (zweiter Teil des Integrals des Antriebsstroms) die Verluste in Elektromotor 32, Getriebe 33 etc. angibt. Der Teil I wird von dem Rest unterschieden, indem vom Zeitpunkt t₂ an nur die über dem Momentanwert des Antriebsstroms zum Zeitpunkt t₂ liegenden Anteile des Antriebsstroms für den Teil I berücksichtigt werden, bis der Strom wieder unter diesen Momentanwert fällt oder bis der elektrische Hilfsantrieb deaktiviert wird.

Für die Auswertung können das Integral und/oder die Teile des Integrals betrachtet werden. Auch ist es möglich, das Integral oder seine Teile miteinander ins Verhältnis zu setzen und diese Verhältnisse bei der Auswertung zu berücksichtigen.

Unabhängig von den Einzelheiten der Auswertung eines Ausführungsbeispiels des erfindungsgemäßen Verfahrens wird hierbei ein Auswertungsdatensatz erstellt, der den aktuellen Zustand des Federspeicherantriebs möglichst aussagekräftig beschreibt und anschließend mit einer Erwartung, beispielsweise einem älteren Auswertungsdatensatz, einem im Rahmen der Herstellung des Federspeicherantriebs bei einer initialen Messung gewonnenen entsprechenden Datensatz oder einer für den Bautyp des Federspeicherantriebs typischen Datensatz, verglichen. Abhängig von einem Ergebnis des Vergleichs kann dann Wartungssignal ausgegeben werden. Beispielsweise kann die Notwendigkeit einer Wartungsmaßnahme angezeigt werden, wenn der Auswertungsdatensatz oder einzelne Daten des Auswertungsdatensatzes um mehr als eine vorbestimmte Fehlertoleranz von der Erwartung abweichen. Je nach Ausführungsvariante des Verfahrens können auch die Art des wahrscheinlichen Fehlers und/oder die betroffene Komponente durch das Wartungssignal signalisiert werden.

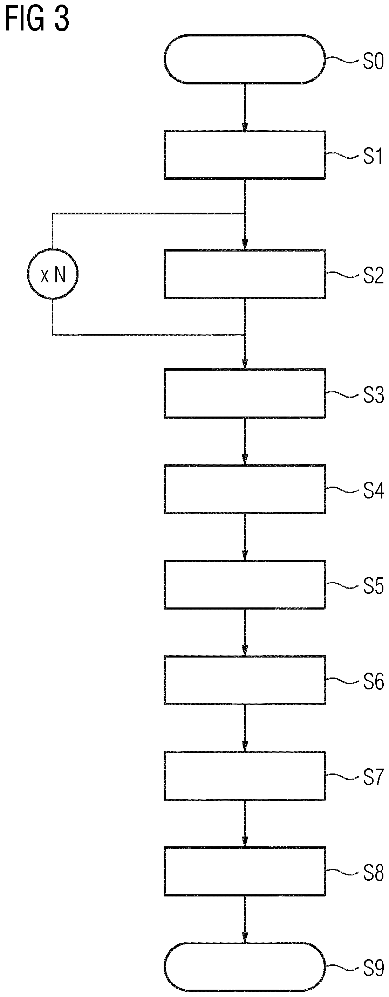

Fig. 3 zeigt ein Ausführungsbeispiel eines erfindungsgemäßen Verfahrens zum Betreiben des Federspeicherantriebs. Das Verfahren beginnt in einem Startschritt S0 und setzt anschließend mit einem Schritt S1 fort, in dem der elektrische Hilfsantrieb aktiviert wird. Nach dem Aktivieren des elektrischen Hilfsantriebs wird wiederholt ein Schritt S2 ausgeführt, in dem der Antriebsstrom des elektrischen Hilfsantriebs gemessen wird, während die Antriebsfeder des Federspeicherantriebs gespannt wird. Hierdurch wird der zeitliche Verlauf des Antriebsstroms gemessen.

Es sei hier angemerkt, dass es prinzipiell nicht wichtig ist, ob das Messen des Antriebsstroms gleichzeitig mit dem Aktivieren des elektrischen Hilfsantriebes oder davor oder danach begonnen oder überhaupt unabhängig davon fortlaufend ausgeführt wird. Insofern dient die Figur 3 nur zur Veranschaulichung eines Ausführungsbeispiels und zum besseren Verständnis der Erfindung.

In einem Schritt S3 wird ein Integral des Antriebsstroms bestimmt. Dieser Schritt kann statt wie in Figur 3 gezeigt nach dem Messen des gesamten zeitlichen Verlaufs auch parallel mit dem Schritt S2 durch fortlaufendes Kumulieren der einzelnen Messwerte durchgeführt werden. Anschließend wird in einem Schritt S4 der zu Figur 2 erläuterte erste Teil des Integrals und in einem Schritt S5 der zweite Teil des Integrals bestimmt. Die Reihenfolge der Schritte S4 und S5 kann selbstredend vertauscht werden. Auch ist es möglich, eine Größe von Integral, ersten Teil des Integrals und zweitem Teil des Integrals durch Summen- oder Differenzbildung aus den anderen beiden Größen zu bestimmen. In Schritt S6 wird ein Auswertungsdatensatz erstellt, der eine beliebige Kombination der Messwerte, des Integrals, dessen Teile und/oder deren Verhältnis(se) oder auch nur eine einzelne der genannten Größen enthalten kann. In Schritt S7 wird dieser Auswertungsdatensatz mit einer Erwartung verglichen und schließlich in einem Schritt S8 abhängig von einem Ergebnis des Vergleichs ein Wartungssignal ausgegeben, bevor das Verfahren bis zu dem nächsten Spannen der Antriebsfeder in einem Endschritt S9 beendet wird. Auf das Wartungssignal hin kann eine geeignete Wartungsmaßnahme geplant und die Mittelspannungsanlage zu einem günstigen Zeitpunkt für die Durchführung der Wartungsmaßnahme vorübergehend außer Betrieb genommen werden.

Die Erfindung wurde unter Bezugnahme auf Abbildungen von Ausführungsbeispielen näher erläutert. Die Ausführungsbeispiele sollen den Schutzbereich der Erfindung, der allein durch die nachfolgenden Ansprüche definiert wird, nicht einschränken, sondern dienen lediglich dem besseren Verständnis.

### Bezugszeichenliste

- 10: Mittelspannungsschaltanlage

- 20: Schalter
- 21: Bewegtkontakt
- 22: Gegenkontakt

- 30: Federspeicherantrieb
- 31: elektrischer Hilfsantrieb
- 32: Elektromotor
- 33: Getriebe
- 34: Antriebsfeder
- 35: Auslöser
- 36: Umsetzung
- 37: Messeinheit, Steuereinheit
- 38: Signalempfänger

## Patentansprüche

1. Ein Verfahren zum Betreiben eines Federspeicherantriebs (30) einer Mittelspannungsschaltanlage (10) mit den Schritten:
- Messen eines Antriebsstroms eines elektrischen Hilfsantriebs (31) zum Spannen einer Antriebsfeder (34) des Federspeicherantriebs (30) der Mittelspannungsanlage (10);
- Spannen der Antriebsfeder (34) mit dem elektrischen Hilfsantrieb (31);
- Erstellen eines Auswertungsdatensatzes in Abhängigkeit von dem gemessenen Antriebsstrom;
- Vergleichen des Auswertungsdatensatzes mit einer Erwartung; und
- Ausgeben eines Wartungssignals in Abhängigkeit von einem Ergebnis des Vergleichens,
wobei im Schritt des Messens des Antriebsstroms ein zeitlicher Verlauf des Antriebsstroms gemessen wird und bei dem der Auswertungsdatensatz in Abhängigkeit von dem gemessenen zeitlichen Verlauf des Antriebsstroms erstellt wird, **dadurch gekennzeichnet, dass** im Schritt des Erstellens des Auswertungsdatensatzes ein Integral des zeitlichen Verlaufs des Antriebsstroms bestimmt wird und dass dabei ein erster Anteil des Integrals bestimmt wird, der eine von dem Hilfsantrieb geleistete Spannarbeit angibt.

2. Das Verfahren des vorhergehenden Anspruchs, bei dem ein zweiter Anteil des Integrals bestimmt wird, der Antriebsverluste des Hilfsantriebs (31) angibt.

3. Das Verfahren der beiden vorhergehenden Ansprüche, bei dem der erste und der zweite Anteil des Integrals zueinander ins Verhältnis gesetzt werden.

4. Das Verfahren eines der vorhergehenden Ansprüche, bei dem beim Erstellen des Auswertungsdatensatzes wenigstens ein charakteristischer Zeitpunkt (t₁, t₂, t₃, t₄, t₅) bestimmt wird und bei dem im Schritt des Vergleichens des Auswertungsdatensatzes der wenigstens eine charakteristische Zeitpunkt (t₁, t₂, t₃, t₄, t₅) und/oder ein zu dem wenigstens einen charakteristische Zeitpunkt (t₁, t₂, t₃, t₄, t₅) gemessener Antriebsstrom mit einem dem wenigstens einen charakteristischen Zeitpunkt (t₁, t₂, t₃, t₄, t₅) zugeordneten Erwartungswert verglichen wird.

5. Das Verfahren des vorhergehenden Anspruchs, bei dem der wenigstens eine charakteristische Zeitpunkt (t₁, t₂, t₃, t₄, t₅) ein Zeitpunkt ausgewählt aus dem Beginn eines Stromflusses durch den Hilfsantrieb (31), dem Beginn des Spannens der Antriebsfeder, dem Auftreten eines lokalen oder globalen Maximums des Antriebsstroms, dem Abschaltzeitpunkt des Hilfsantriebs (31) und dem Ende eines Stromflusses durch den Hilfsantrieb (31) ist.

6. Das Verfahren eines der vorhergehenden Ansprüche, bei dem die Erwartung ein historischer Datensatz oder ein für einen Typ des Federspeicherantriebs spezifischer vorgegebener Datensatz ist.

7. Ein Federspeicherantrieb (30) für eine Mittelspannungsschaltanlage (10) und mit einem elektrischen Hilfsantrieb (31), der ausgebildet ist, eine Antriebsfeder (34) des Federspeicherantriebs (30) zu spannen, und einer Messeinheit (37), die ausgebildet ist, einen Antriebsstrom des Hilfsantriebs (31) zu messen und ein Messergebnis an eine Steuereinheit (37) zur Durchführung des Verfahrens gemäß einem der vorhergehenden Ansprüche zu übermitteln.

8. Eine Mittelspannungsschaltanlage (10) mit einem Schalter (20), der einen Bewegtkontakt (21) aufweist, und einem Federspeicherantrieb (30) gemäß dem vorhergehenden Anspruch, welcher ausgebildet ist, den Bewegtkontakt (21) des Schalters (20) auf ein Steuersignal hin zu bewegen.

9. Ein Datenspeicher mit einem Computerprogramm, das, von einer Steuereinheit (37), beispielsweise einer Steuereinheit (37) eines Federspeicherantriebs (30), einer Mittelspannungsschaltanlage (10), eines digitalen Schutzgerätes oder einer entfernten Steuerzentrale, ausgeführt das Verfahren eines der Ansprüche 1 bis 6 durchführt.

## Claims

1. Method for operating a spring energy store drive (30) of a medium-voltage switchgear installation (10), comprising the following steps:
- measuring a drive current of an electric auxiliary drive (31) for tensioning a drive spring (34) of the spring energy store drive (30) of the medium-voltage switchgear installation (10);
- tensioning the drive spring (34) by means of the electric auxiliary drive (31);
- creating an evaluation data set depending on the measured drive current;
- comparing the evaluation data set with an expectation; and
- outputting a maintenance signal depending on a result of the comparing,
wherein a temporal profile of the drive current is measured in the step of measuring the drive current and wherein the evaluation data set is created depending on the measured temporal profile of the drive current, **characterized in that** an integral of the temporal profile of the drive current is determined in the step of creating the evaluation data set, and **in that** in this case a first portion of the integral is determined, which indicates a tensioning work performed by the auxiliary drive.

2. Method of the preceding claim, wherein a second portion of the integral is determined, which indicates drive losses of the auxiliary drive (31).

3. Method of the two preceding claims, wherein the first and second portions of the integral are expressed as a relationship with respect to one another.

4. Method of any of the preceding claims, wherein at least one characteristic point in time (t₁, t₂, t₃, t₄, t₅) is determined when creating the evaluation data set and wherein, in the step of comparing the evaluation data set, the at least one characteristic point in time (t₁, t₂, t₃, t₄, t₅) and/or a drive current measured at the at least one characteristic point in time (t₁, t₂, t₃, t₄, t₅) are/is compared with an expectation value assigned to the at least one characteristic point in time (t₁, t₂, t₃, t₄, t₅).

5. Method of the preceding claim, wherein the at least one characteristic point in time (t₁, t₂, t₃, t₄, t₅) is a point in time selected from the beginning of a current flow through the auxiliary drive (31), the beginning of the tensioning of the drive spring, the occurrence of a local or global maximum of the drive current, the switch-off point in time of the auxiliary drive (31) and the end of a current flow through the auxiliary drive (31).

6. Method of any of the preceding claims, wherein the expectation is a historical data set or a predefined data set specific to a type of spring energy store drive.

7. Spring energy store drive (30) for a medium-voltage switchgear installation (10) and comprising an electric auxiliary drive (31) configured to tension a drive spring (34) of the spring energy store drive (30), and comprising a measuring unit (37) configured to measure a drive current of the auxiliary drive (31) and to communicate a measurement result to a control unit (37) for carrying out the method according to any of the preceding claims.

8. Medium-voltage switchgear installation (10) comprising a switch (20) having a moving contact (21), and comprising a spring energy store drive (30) according to the preceding claim, which is configured to move the moving contact (21) of the switch (20) in response to a control signal.

9. Data storage device comprising a computer program which, when executed by a control unit (37), for example a control unit (37) of a spring energy store drive (30), of a medium-voltage switchgear installation (10), of a digital protection device or of a remote control centre, carries out the method of any of Claims 1 to 6.

## Revendications

1. Un procédé pour faire fonctionner un entraînement (30) à ressort accumulateur d'une installation (10) de coupure de moyenne tension comprenant les stades :
- mesure d'un courant d'entraînement d'un entraînement (31) électrique auxiliaire pour tendre un ressort (34) d'entraînement de l'entraînement (30) à ressort accumulateur de l'installation (10) de moyenne tension ;
- tension du ressort (34) d'entraînement par l'entraînement (31) électrique auxiliaire ;
- établissement d'un ensemble de données d'évaluation en fonction du courant d'entraînement mesuré ;
- comparaison de l'ensemble de données d'évaluation à ce que l'on attend ; et
- émission d'un signal d'entretien en fonction du résultat de la comparaison,
dans lequel, dans le stade de mesure du courant d'entraînement, on mesure une courbe en fonction du temps du courant d'entraînement et dans lequel on établit l'ensemble de données d'évaluation en fonction de la courbe en fonction du temps mesurée du courant d'entraînement, **caractérisé en ce que**, dans le stade d'établissement de l'ensemble de données d'évaluation, on détermine une intégrale de la courbe en fonction du temps du courant d'entraînement et **en ce que** l'on détermine ainsi une première composante de l'intégrale, qui indique un travail de tension fourni par l'entraînement auxiliaire.

2. Le procédé de la revendication précédente, dans lequel on détermine une deuxième composante de l'intégrale, qui indique des pertes de l'entraînement (31) auxiliaire.

3. Le procédé des deux revendications précédentes, dans lequel on met la première et la deuxième composantes de l'intégrale en rapport l'une avec l'autre.

4. Le procédé de l'une des revendications précédentes, dans lequel, lors de l'établissement de l'ensemble de données d'évaluation, on détermine au moins un instant (t₁, t₂, t₃, t₄, t₅) caractéristique et dans lequel, dans le stade de comparaison de l'ensemble de données d'évaluation, on compare le au moins un instant (t₁, t₂, t₃, t₄, t₅) caractéristique et/ou un courant d'entraînement au au moins un instant (t₁, t₂, t₃, t₄, t₅) caractéristique à une valeur escomptée affectée au au moins un instant (t₁, t₂, t₃, t₄, t₅) caractéristique.

5. Le procédé de l'une des revendications précédentes, dans lequel le au moins un instant (t₁, t₂, t₃, t₄, t₅) caractéristique est un instant choisi parmi le début d'un flux de courant dans l'entraînement (31) auxiliaire, le début de la tension du ressort d'entraînement, l'apparition d'un maximum local ou global du courant d'entraînement, l'instant de débranchement de l'entraînement (31) auxiliaire et la fin d'un flux de courant dans l'entraînement (31) auxiliaire.

6. Le procédé de l'une des revendications précédentes, dans lequel ce à quoi l'on s'attend est un ensemble de données historique ou un ensemble de données donné à l'avance spécifique pour un type de l'entraînement à ressort accumulateur.

7. Un entraînement (30) à ressort accumulateur pour une installation (10) de coupure de moyenne tension et comprenant un entraînement (31) électrique auxiliaire, qui est constitué pour tendre un ressort (34) d'entraînement de l'entraînement (30) à ressort accumulateur, et une unité (37) de mesure, qui est constituée pour mesurer un courant de l'entraînement (31) auxiliaire et pour transmettre un résultat de mesure à une unité (37) de commande pour effectuer le procédé suivant l'une des revendications précédentes.

8. Une installation (10) de coupure de moyenne tension comprenant un interrupteur (20), qui a un contact (21) mobile et un entraînement (30) à ressort accumulateur suivant la revendication précédente, qui est constitué pour, sur un signal de commande, déplacer le contact (21) mobile de l'interrupteur (20).

9. Une mémoire de données comprenant un programme d'ordinateur qui, par une unité (37) de commande, par exemple par une unité (37) de commande d'un entraînement (30) à ressort accumulateur, d'une installation (10) de coupure à moyenne tension, d'un appareil de protection numérique ou d'une centrale de commande à distance, exécute le procédé de l'une des revendications 1 à 6.
